# EUROPEAN PATENT APPLICATION

(11) **EP 4 822 667 A2**
(43) Date of publication of application: **14.10.2026**
(21) Application number: 26168871.7
(22) Date of filing: 30.03.2026
(51) Int. Cl.: G08B 17/113, H01M 50/204, H05K 9/00

(54) **FIRE DETECTOR AND ENERGY STORAGE SYSTEM INCLUDING THE SAME**

(30) Priority: 09.04.2025 KR 20250046242
(71) Applicant: SAMSUNG SDI CO., LTD., Yongin-si, Gyeonggi-do 17084 (KR)
(72) Inventor: Seo, Jeawon, 17084 Yongin-si, Gyeonggi-do (KR); Jeon, Sangjin, 17084 Yongin-si, Gyeonggi-do (KR)
(74) Representative: Meissner Bolte Partnerschaft mbB

(57) **Abstract**

A fire detector (100, 200) includes: a detection device (110), 210); a cover member (120, 230) surrounding the detection device (110, 210); and a conductor wire (240) positioned such that one side thereof contacts at least one area of the cover member (120, 230), wherein the cover member (120, 230) comprises a mesh, and another side of the conductor wire (240) is grounded.

## Description

### BACKGROUND

### 1. Field

The present invention relates to a fire detector and an energy storage system including the same.

### 2. Description of the Related Art

An energy storage system may be a system in which a plurality of battery modules are integrated to facilitate battery storage and management and may store electricity produced in a power plant or supply the stored electricity to houses, factories, buildings, or companies that require electricity.

In energy storage systems in which a plurality of battery modules are integrated in this way, in the event of a fire caused by thermal runaway of a battery, there is a possibility that the fire may lead to massive fire. To prevent or reduce a fire, it may be desirable to have a fire detection technology or system capable of relatively quickly and accurately detecting a fire at the early stage.

The above information disclosed in this Background section is only for enhancement of understanding of the background and therefore the information discussed in this Background section does not necessarily constitute prior art.

### SUMMARY

The present invention includes a fire detector with relatively improved stability, and an energy storage system.

However, the technical characteristics of embodiments according to the present invention are not limited to the above characteristics, and other characteristics that are not described herein will be more clearly understood by those skilled in the art from the following descriptions of the present invention.

According to the present invention, a fire detector includes a detection device, a cover member surrounding the detection device, and a conductor wire positioned such that one side thereof is in contact with at least one area of the cover member, wherein the cover member includes a mesh, and another side of the conductor wire is grounded.

According to some embodiments, the mesh may have a size of 30 mesh to 60 mesh.

According to some embodiments, the mesh may include a plurality of holes, and the plurality of holes may have a size of 0.29 mm to 0.62 mm.

According to some embodiments, the mesh may include conductive material, the conductive material may include at least one selected from copper, aluminum, nickel, stainless steel, or silver.

According to some embodiments, the conductive material may be plated with tin or zinc.

According to some embodiments, a form of the mesh may include at least one selected from plain weave, twill weave, or crimp weave.

According to some embodiments, the cover member may include a first cover member and a second cover member which are coupled to each other, the first cover member may have a first concave portion formed in one surface of the first cover member, the second cover member may have a second concave portion formed in one surface of the second cover member, and the first concave portion and the second concave portion may be positioned to overlap each other when the first cover member and the second cover member are coupled to each other.

According to the present invention, an energy storage system includes a plurality of battery modules, a battery rack on which the plurality of battery modules are mounted, at least one fire detector positioned on an upper end of the battery rack, and a control device electrically connected to the plurality of battery modules and the at least one fire detector, wherein the at least one fire detector further includes a conductor wire, and the conductor wire has one side in contact with at least one area of the at least one fire detector and another side in contact with the battery rack.

According to some embodiments, the at least one fire detection device may further include a detection device, and a cover member surrounding the detection device, the one side of the conductor wire may be in contact with at least one area of the cover member, and the cover member may include a mesh.

According to some embodiments, the mesh may have a size of 30 mesh to 60 mesh.

According to some embodiments, the mesh may include a plurality of holes, and the plurality of holes may have a size of 0.29 mm to 0.62 mm.

According to some embodiments, the mesh may include conductive material, the conductive material may include at least one selected from copper, aluminum, nickel, stainless steel, or silver.

According to some embodiments, the conductive material may be plated with tin or zinc.

According to some embodiments, a form of the mesh may include at least one selected from plain weave, twill weave, or crimp weave.

According to some embodiments, the cover member may include a first cover member and a second cover member which are coupled to each other, the first cover member may have a first concave portion formed in one surface of the first cover member, the second cover member may have a second concave portion formed in one surface of the second cover member, and the first concave portion and the second concave portion may be positioned to overlap each other when the first cover member and the second cover member are coupled to each other.

According to some embodiments, a first opening may be positioned in another surface of the first cover member which intersects the one surface in which the first concave portion of the first cover member is formed, a second opening may be positioned in another surface of the second cover member which intersect with the one surface in which the second concave portion of the second cover member is formed, and the first opening and the second opening may be positioned to overlap each other when the first cover member and the second cover member are coupled to each other.

According to some embodiments, the one side of the conductor wire may be in contact with an area in which the first opening and the second opening are positioned to overlap each other when the first cover member and the second cover member are coupled to each other.

According to some embodiments, the energy storage system may further include a first bracket to which the detection device is fixed, and a second bracket at one side of the first bracket, and the second bracket may be in contact with the battery rack.

According to some embodiments, the other side of the conductor wire may be grounded.

According to some embodiments, the energy storage system may further include a solenoid valve, and the solenoid valve may be electrically connected to the control device and may be operated by an electrical signal generated by the at least one fire detector.

### BRIEF DESCRIPTION OF THE DRAWINGS

The accompanying drawings illustrate aspects of some embodiments of the present invention and, together with the following detailed description, serve to provide further understanding of the technical spirit of embodiments according to the present invention. However, the present invention is not to be construed as being limited to the details shown in the drawings, in which:
FIG. 1 is a schematic exploded perspective view illustrating an example of a fire detector according to some embodiments of the present invention;
FIG. 2 is a schematic perspective view illustrating an example of a coupling of the fire detector of FIG. 1;
FIG. 3 shows enlarged views of area A of FIG. 1;
FIG. 4 is a schematic exploded perspective view illustrating an example of a fire detector according to some embodiments of the present invention;
FIG. 5 is a schematic perspective view illustrating an example of a coupling of the fire detector of FIG. 4;
FIG. 6 is a schematic cross-sectional view illustrating an example of an energy storage system to which a fire detector is applied;
FIG. 7 is a schematic perspective view illustrating an example of a battery rack in area B of FIG. 6;
FIG. 8 is a side view of area C of FIG. 7;
FIG. 9 shows schematic views illustrating an example of the operation of a fire extinguishing system of an energy storage system;
FIGS. 10A to 10C are graphs showing a detection waveform of a fire detector;
FIG. 11 shows graphs showing a detection waveform of a fire detector according to a mesh size; and
FIG. 12 is a graph showing a response time of a fire detector according to a mesh size.

### DETAILED DESCRIPTION

Hereinafter, aspects of some embodiments of the present invention will be described with reference to the accompanying drawings. Prior to the description, it should be understood that the terms used in the specification and the appended claims should not be construed as limited to general and dictionary meanings, but interpreted based on the meanings and concepts corresponding to technical aspects of the present invention on the basis of the principle that the inventor is allowed to define terms appropriately for the best description. Accordingly, embodiments disclosed in the present specification and configurations illustrated in the drawings are merely example embodiments of the present invention and do not represent all of the technical ideas of the present invention, and thus it should be understood that there may be various equivalents and modifications that can substitute these at the time of filing of the present application.

Further, "comprise and include" and/or "comprising and including" used in this specification should be interpreted as specifying the presence of described shapes, numbers, steps, operations, members, elements, and/or groups thereof and do not exclude the presence or addition of other shapes, numbers, operations, members, elements, and/or groups thereof.

In addition, for a better understanding of the present invention, the accompanying drawings are not illustrated on an actual scale and sizes of some elements may be exaggerated. In addition, the same reference numbers may be assigned to the same components in different embodiments.

It will be understood that, although the terms first, second, and the like are used herein to describe various components, these components should not be limited by these terms. These terms are only used to distinguish one component from another component, and a first component may also be a second component unless particularly described otherwise.

Through the specification, each component may be singular or plural unless particularly described otherwise.

When it is said that an arbitrary element is located on "an upper portion (or a lower portion)" of an element or located "above (or below)" an element, this may not only mean that the arbitrary element is located in contact with an upper surface (or a lower surface) of the element, but also mean that another element may be interposed between the element and the arbitrary element located above (or below) the element.

Also, when it is said that a first element is "connected" or "coupled" to a second element, this may mean that the elements are directly connected or coupled to each other, but it should be understood that a third element may be "interposed" between the elements or the elements may be "connected" or "coupled" to each other via the third element. Further, the term "electrically coupled" may mean not only "directly coupled" but also may include "coupled via other interposing component."

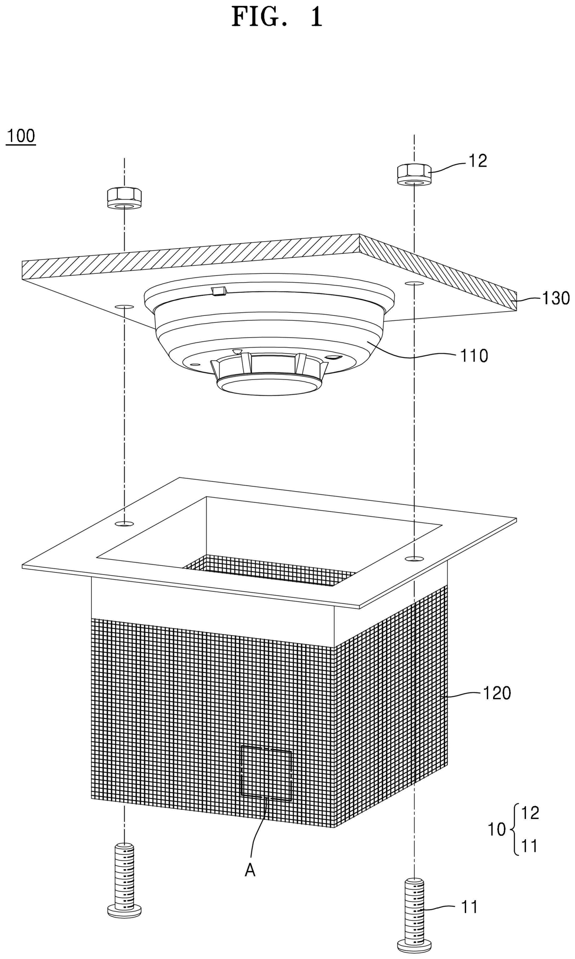

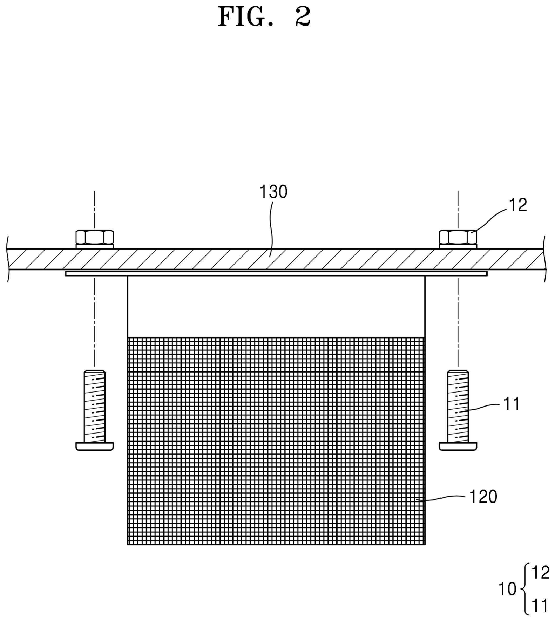

FIG. 1 is a schematic exploded perspective view illustrating an example of a fire detector 100 according to some embodiments of the present invention. FIG. 2 is a schematic perspective view illustrating an example of a coupling of the fire detector 100 of FIG. 1.

Referring to FIGS. 1 and 2, the fire detector 100 may include a detection device 110 and a cover member 120 arranged to surround the detection device 110.

The detection device 110 may be fixedly located on a fixing target surface 130 and may detect a fire in case of fire. In this case, the fixing target surface 130 may include, for example, a ceiling or a wall surface.

The detection device 110 may include, for example, a heat detector using a resistor such as a thermistor of which a resistance value sensitively changes according to a temperature change, a smoke detector including a photoelectric element that detects smoke generated by a fire, an infrared detector including an infrared sensor that detects infrared rays emitted from a flame, or the like.

The cover member 120 may be located on the detection device 110 to cover the detection device 110 and may be arranged to surround the entire detection device 110 and be fixed to the fixing target surface 130 through a fixing member 10. The fixing member 10 may include, for example, a bolt 11 and a nut 12, but embodiments according to the present invention are not limited thereto. The fixing member 10 may include any component as long as the component may fix the cover member 120 to the fixing target surface 130.

The cover member 120 may include, for example, a shape that may cover the entire detection device 110 and may include, for a specific example, a polyhedral shape or a dome shape. In addition, at least one area of the cover member 120 with a polyhedral shape or a dome shape may include a mesh.

The mesh may include, for example, a conductive material and may include, for a specific example, a metal thread.

For example, a plurality of metal threads may be arranged to intersect each other to form a plurality of holes in the mesh, and the mesh may be manufactured in various forms according to a method of intersecting the metal threads.

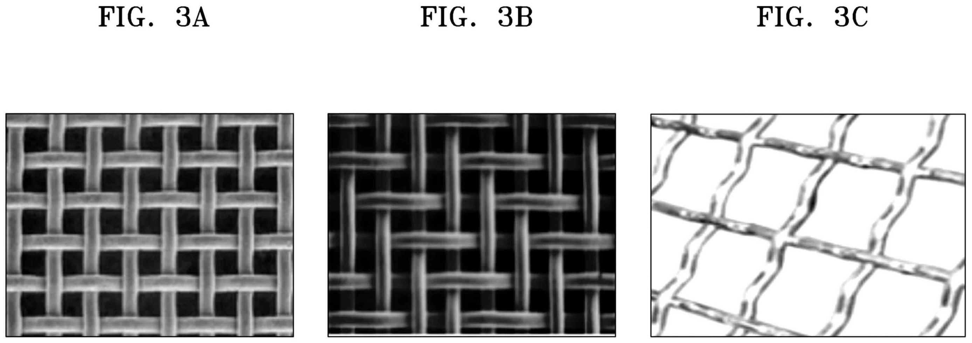

FIG. 3 shows enlarged views of area A of FIG. 1.

Referring to FIG. 3, a mesh may be manufactured in the form of plain weave (see FIG. 3A), twill weave (see FIG. 3B), or crimp weave (see FIG. 3C) according to a method of intersecting metal threads. In this case, a plurality of intersecting metal threads may be spaced apart from each other to manufacture a mesh including a plurality of holes.

For example, by arranging the mesh in one area of the cover member 120 that surrounds the detection device 110, the cover member 120 may allow smoke generated together with a fire to easily pass therethrough, thereby allowing the smoke to be detected by the detection device 110, and foreign materials such as dust may be blocked to prevent or reduce the detection device 110 being exposed to foreign materials, thereby preventing or reducing a deterioration in performance. In addition, the mesh may be made of a conductive metal thread to block radiation noise caused by electromagnetic waves generated by surrounding electronic devices, thereby preventing or reducing a malfunction of the detection device 110.

For example, a size of a mesh may be in a range of 30 mesh to 60 mesh, and in this case, a unit of the mesh may be defined as the number of holes included in a 1 square inch area (2.54 cm×2.54 cm) of the mesh. For example, 30 mesh may mean that the number of holes included in a 1 square inch area (2.54 cm×2.54 cm) of the mesh is 30.

The mesh included in the cover member 120 may have different hole sizes according to mesh sizes. For example, as a mesh size decreases, a hole size may increase, and as a mesh size increases, as an example, a hole size may decrease.

For example, a size of a hole refers to the longest length when the hole is measured. For example, when a hole has a circular shape, a size of the hole may be a diameter of a line passing through the center. When a hole has a quadrangular shape, a size of the hole may be a length of a diagonal.

For example, a size of the hole may be in a range of 0.29 mm to 0.62 mm. When the mesh may have such a size of a hole, the mesh may effectively block the passage of radiation noise and effectively allow the passage of smoke.

As an example, when the size of the mesh is 30 mesh or more, the size of the hole may be 0.62 mm or less, and when the size of the mesh is 60 mesh or less, the size of the hole may be 0.29 mm or more.

For example, a diameter of a metal thread may vary according to a size of a mesh, and a diameter of the metal thread may have different values according to each size of the mesh.

In some embodiments, when the size of the mesh is less than 30 mesh, it may be difficult to block radiation noise, and when the size of the mesh exceeds 60 mesh, there may be a problem in that it takes a long time for the detection device 110 to detect smoke because it is difficult for smoke generated together with a fire to pass through the mesh.

For example, when the size of the hole is less than 0.29 mm, there may be a problem in that it takes a long time for the detection device 110 to detect smoke because it may be relatively difficult for smoke generated together with a fire to pass through the hole, and when the size of the hole exceeds 0.62 mm, it may be relatively difficult to block radiation noise.

According to some embodiments, the conductive material may include at least one selected from copper, aluminum, nickel, stainless steel, or silver.

According to some embodiments, a surface of the conductive material may be additionally plated with tin or zinc, and by plating the surface of the conductive material with tin or zinc, corrosion of the conductive member may be prevented or reduced.

According to some embodiments, the fire detector 100 may further include a conductor wire of which one side is positioned in contact with at least one area of the cover member 120, and the other side of the conductor wire may be grounded.

The conductor wire may be grounded by being in contact with the cover member 120 so that radiant noise due to electromagnetic waves may flow along the cover member 120 made of a conductive material and then may flow to a ground surface along the conductor wire in contact with the cover member 120. In this way, radiation noise may flow to a ground surface along the cover member 120 and the conductor wire so that the cover member 120 may block radiation noise, and the cover member 120 may block radiation noise radiated to the detection device 110 so that a malfunction of the detection device 110 due to radiation noise may be prevented or reduced.

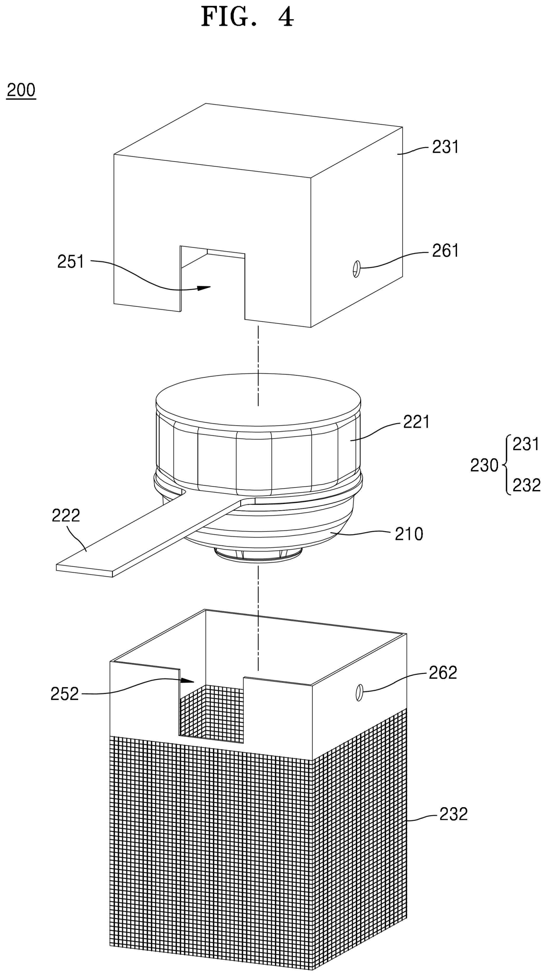

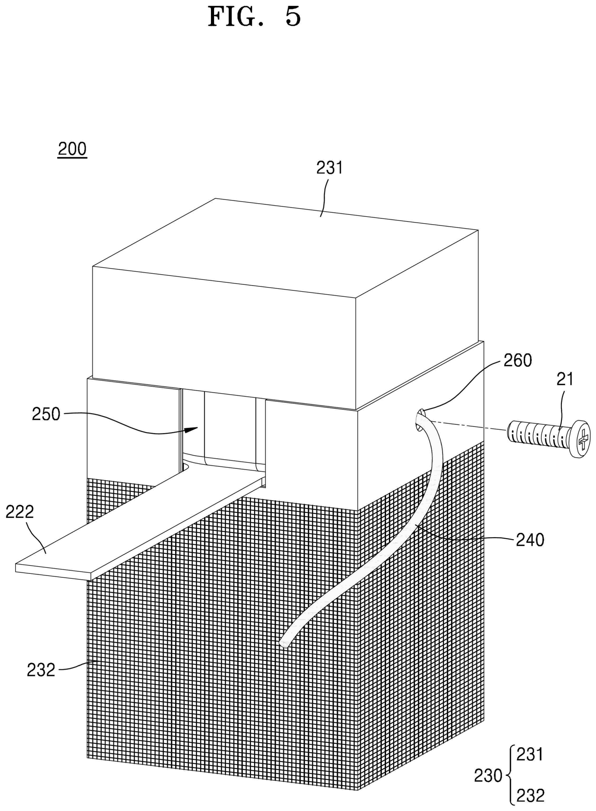

FIG. 4 is a schematic exploded perspective view illustrating an example of a fire detector 200 according to some embodiments of the present invention. FIG. 5 is a schematic perspective view illustrating an example of a coupling of the fire detector 200 of FIG. 4.

Referring to FIGS. 4 and 5, the fire detector 200 may include a detection device 210, a cover member 230 arranged to surround the detection device 210, and a conductor wire 240 of which one side is positioned in contact with at least one area of the cover member 230, and the cover member 230 may include a first cover member 231 and a second cover member 232.

The detection device 210 may be fixedly located on a first bracket 221 and may detect a fire in case of fire. In this case, the first bracket 221 may include, for example, an octagonal box or a quadrangular box located on the detection device 210, and the octagonal box or the quadrangular box may be a box for wiring the detection device 210 so that electric wires connected to the detection device 210 may be accommodated in the box. The electric wires may be connected to a control unit of an energy storage system to be described below.

For example, a second bracket 222 with a shape of a long bar may be located at one side of the first bracket 221. The second bracket 222 may be fixed in contact with a battery rack of the energy storage system to be described below and thus may fix the fire detector 200 to the battery rack of the energy storage system to be spaced apart from the battery rack.

The detection device 210 may include, for example, a heat detector using a resistor such as a thermistor of which a resistance value sensitively changes according to a temperature change, a smoke detector including a photoelectric element that detects smoke generated by a fire, an infrared detector including an infrared sensor that detects infrared rays emitted from a flame, or the like.

The cover member 230 may be arranged to surround the entire detection device 210 fixed to the first bracket 221. In this case, the second bracket 222 located at one side of the first bracket 221 may protrude outward through an opening 250 of the cover member 230.

The cover member 230 may include, for example, the first cover member 231 and the second cover member 232.

The first cover member 231 may include a conductive material, may include a polyhedral shape or a dome shape, and may be arranged to cover an upper portion of the detection device 210 fixed to the first bracket 221, and the second cover member 232 may include a conductive material, may include a polyhedral or a dome shape, and may be arranged to cover a lower portion of the detection device 210.

According to some embodiments, the first cover member 231 may include a polyhedron. For example, a first concave portion 251 may be formed in one surface of the first cover member 231 and may be positioned to overlap a second concave portion 252 formed in one surface of the second cover member 232 to be described below. As a specific example, the first concave portion 251 formed in one surface of the first cover member 231 and the second concave portion 252 formed in one surface of the second cover member 232 may be arranged to overlap each other when the first cover member 231 and the second cover member 232 are coupled to each other, thereby forming the opening 250. The second bracket 222 may protrude outward from the cover member 230 through the opening 250.

In addition, as an example, the first cover member 231 may have a first opening 261 positioned in the other surface of the first cover member 231 which intersects one surface in which the first concave portion 251 is formed. The first opening 261 may be arranged to overlap a second opening 262 of the second cover member 232 to be described below. As a specific example, the first opening 261 of the first cover member 231 and the second opening 262 of the second cover member 232 may be arranged to overlap each other when the first cover member 231 and the second cover member 232 are coupled to each other, thereby forming a coupling portion 260. A coupling member 21 may be located in the coupling portion 260, thereby coupling and fixing the first cover member 231 and the second cover member 232 to each other.

According to some embodiments, the second cover member 232 may include a polyhedral shape corresponding to the first cover member 231. As an example, one area of the second cover member 232 may include a mesh, and the other area thereof except for one area including the mesh may include a coupling area arranged to overlap the first cover member 231.

The second concave portion 252 may be formed in one surface of the second cover member 232, may be formed in a coupling area of the second cover member 232, and may be arranged to overlap the first concave portion 251 formed in one surface of the first cover member 231. As a specific example, the second concave portion 252 formed in one surface of the second cover member 232 and the first concave portion 251 formed in one surface of the first cover member 231 may be arranged to overlap each other when the first cover member 231 and the second cover member 232 are coupled to each other, thereby forming the opening 250. The second bracket 222 may protrude outward from the cover member 230 through the opening 250.

In addition, as an example, the second cover member 232 may have the second opening 262 formed in the other surface of the second cover member 232 which intersects one surface in which the second concave portion 252 is formed. The second opening 262 may be formed in a coupling area of the second cover member 232 and may be arranged to overlap the first opening 261 formed in the other surface of the first cover member 231. As a specific example, the second opening 262 of the second cover member 232 and the first opening 261 of the first cover member 231 may be arranged to overlap each other when the first cover member 231 and the second cover member 232 are coupled to each other, thereby forming the coupling portion 260. The coupling member 21 may be arranged in the coupling portion 260, thereby coupling and fixing the first cover member 231 and the second cover member 232 to each other.

For example, when the coupling member 21 is located in the coupling portion 260, the conductor wire 240 to be described below may be located in the coupling portion 260 together with the coupling member 21 so that one side of the conductor wire 240 may be fixed to the coupling portion 260 by the coupling member 21.

The mesh positioned in one area of the second cover member 232 may include, for example, a conductive material, and as a specific example, may include a metal thread.

For example, a plurality of metal threads may be arranged to intersect each other to form a plurality of holes in the mesh, and the mesh may be manufactured in various forms according to a method of intersecting the metal threads.

A mesh may be manufactured in the form of plain weave, twill weave, or crimp weave according to a method of intersecting metal threads. In this case, a plurality of intersecting metal threads may be spaced apart from each other to manufacture a mesh including a plurality of holes.

For example, by arranging the mesh in one area of the second cover member 232 of the cover member 230 that surrounds the detection device 210, the cover member 220 may allow smoke generated together with a fire to easily pass therethrough, thereby allowing the smoke to be detected by the detection device 210, and foreign materials such as dust may be blocked to prevent or reduce the detection device 210 from being exposed to foreign materials, thereby preventing or reducing a deterioration in performance. In addition, the mesh may be made of a conductive metal thread to block radiation noise caused by electromagnetism generated by surrounding electronic devices, thereby preventing or reducing a malfunction of the detection device 210.

For example, a size of a mesh may be in a range of 30 mesh to 60 mesh, and in this case, a unit of the mesh may be defined as the number of holes included in a 1 square inch area (2.54 cm×2.54 cm) of the mesh. Specifically, 30 mesh may mean that the number of holes included in a 1 square inch area (2.54 cm×2.54 cm) of the mesh is 30.

The mesh included in the cover member 230 may have different hole sizes according to mesh sizes. For example, as a mesh size decreases, a hole size may increase, and as a mesh size increases, as an example, a hole size may decrease.

For example, a size of a hole refers to the longest length when the hole is measured. For example, when a hole has a circular shape, a size of the hole may be a diameter of a line passing through the center. When a hole has a quadrangular shape, a size of the hole may be a length of a diagonal.

For example, a size of the hole may be in a range of 0.29 mm to 0.62 mm. When the mesh may have such a size of a hole, the mesh may effectively block the passage of radiation noise and effectively allow the passage of smoke.

As an example, when the size of the mesh is 30 mesh or more, the size of the hole may be 0.62 mm or less, and when the size of the mesh is 60 mesh or less, the size of the hole may be 0.29 mm or more.

For example, a diameter of a metal thread may vary according to a size of a mesh, and a diameter of the metal thread may have different values according to each size of the mesh.

In some embodiments, when the size of the mesh is less than 30 mesh, it may be difficult to block radiation noise, and when the size of the mesh exceeds 60 mesh, there may be a problem in that it takes a long time for the detection device 210 to detect smoke because it is difficult for smoke generated together with a fire to pass through the mesh.

For example, when the size of the hole is less than 0.29 mm, there may be a problem in that it takes a long time for the detection device 210 to detect smoke because it is difficult for smoke generated together with a fire to pass through the hole, and when the size of the hole exceeds 0.62 mm, it may be difficult to block radiation noise.

According to some embodiments, the conductive material may include at least one selected from copper, aluminum, nickel, stainless steel, or silver.

According to some embodiments, a surface of the conductive material may be additionally plated with tin or zinc, and by plating the surface of the conductive material with tin or zinc, corrosion of the conductive member may be prevented or reduced.

The conductor wire 240 may be positioned such that one side thereof is in contact with at least one area of the cover member 230. As a specific example, the conductor wire 240 may be positioned such that one side thereof is in contact with the coupling portion 260 of the cover member 230, and the other side thereof may be grounded.

The conductor wire 240 may be grounded by being in contact with the cover member 230 so that radiant noise due to electromagnetic waves may flow along the cover member 230 made of a conductive material and then may flow to a ground surface along the conductor wire 240 in contact with the cover member 230. In this way, radiation noise may flow to a ground surface along the cover member 230 and the conductor wire 240 so that the cover member 230 may block radiation noise flowing toward the detection device 210, and the cover member 230 may block radiation noise radiated to the detection device 210 so that a malfunction of the detection device 210 due to radiation noise may be prevented or reduced.

As a result, a fire detector according to embodiments of the present invention may include a cover member and a conductor wire in contact with at least one area of the cover member, and thus a malfunction of the fire detector may be prevented or reduced, thereby relatively improving safety.

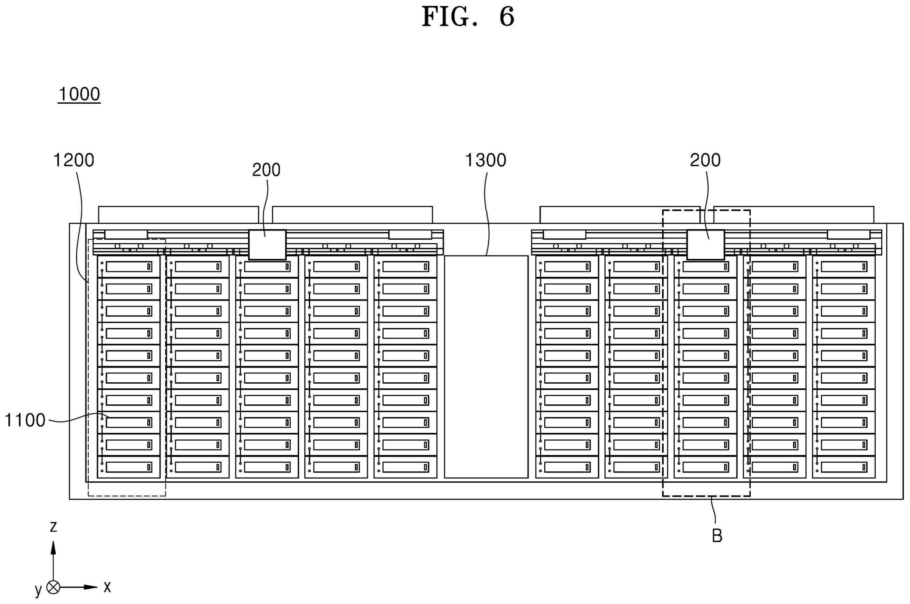

FIG. 6 is a schematic cross-sectional view illustrating an example of an energy storage system 1000 to which the fire detector 200 of FIG. 4 is applied.

Referring to FIG. 6, the energy storage system 1000 may include a plurality of battery modules 1100, battery racks 1200 on which the plurality of battery modules 1100 are mounted, a control device 1300, and at least one fire detector 200 located on an upper end of the battery rack 1200.

A plurality of battery cells which are electrically connected to each other to facilitate storage and management of the battery cells may be accommodated inside the battery module 1100, and the battery module 1100 may be controlled by the control device 1300 by being electrically connected to the control device 1300 to be described below.

A plurality of battery racks 1200 may be located inside the energy storage system 1000, and the plurality of battery modules 1100 may be mounted on the battery rack 1200.

The battery rack 1200 may include, for example, a plurality of layers, and thus the plurality of battery modules 1100 may be mounted on each layer. The battery rack 1200 may include a conductive member and thus may be grounded to be prevented from being short-circuited due to contact with the battery module 1100.

According to some embodiments, the battery rack 1200 may be grounded through a grounding box positioned in the energy storage system 1000.

The control device 1300 may check a state of the battery modules 1100, may control charging/discharging and current flow, and may be connected to the fire detector 200 to receive a detection signal generated by the fire detector 200 to activate a fire extinguishing device, thereby controlling operations of various electronic devices included in the energy storage system 1000.

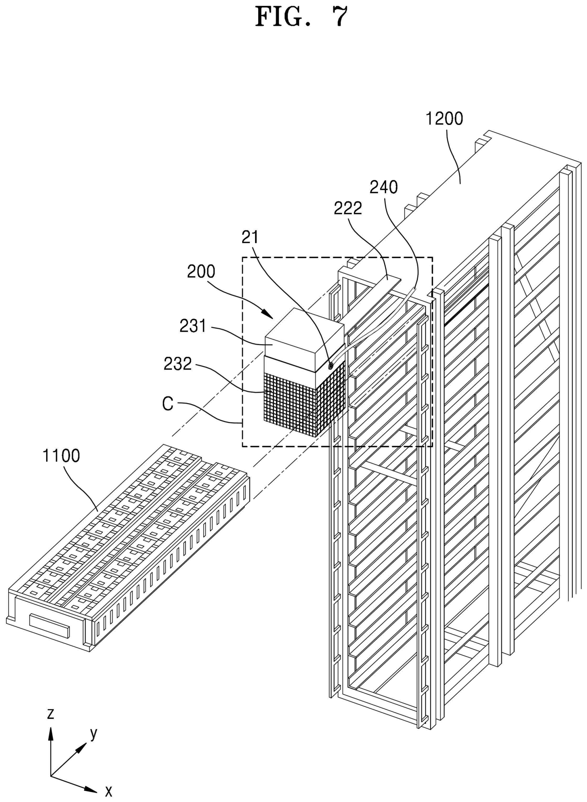

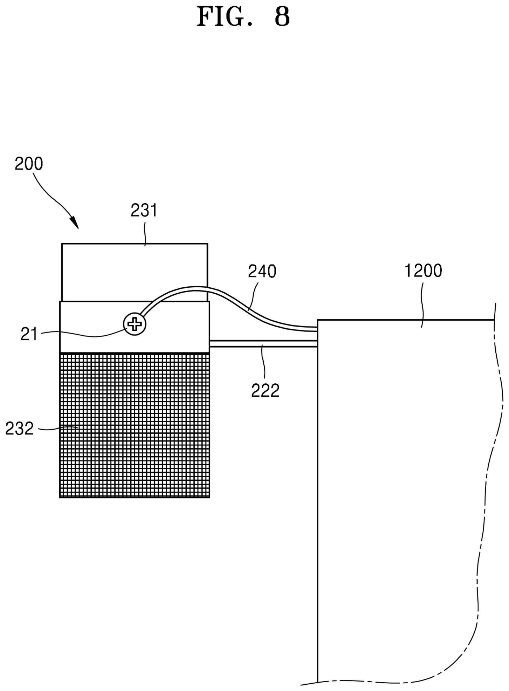

FIG. 7 is a schematic perspective view illustrating an example of the battery rack 1200 in area B of FIG. 6. FIG. 8 is a side view of the battery rack 1200 of FIG. 7.

Referring to FIGS. 7 and 8, the fire detector 200 may be located on an upper end of the battery rack 1200 by fixing the second bracket 222 to a frame of the battery rack 1200.

For example, the detection device 210 may be fixedly arranged on the first bracket 221 inside the fire detector 200, thereby detecting a fire in case of fire. In this case, the first bracket 221 may include, for example, an octagonal box or a quadrangular box located on the detection device 210, and the octagonal box or the quadrangular box may be a box for wiring the detection device 210 so that electric wires connected to the detection device 210 may be accommodated in the box. The electric wires may be connected to a control unit of an energy storage system to be described below.

For example, the second bracket 222 with a shape of a long bar may be located at one side of the first bracket 221 positioned inside the fire detector 200. The second bracket 222 may be fixed in contact with the battery rack 1200 and thus may fix the fire detector 200 to an upper frame of the battery rack 1200 to be spaced apart from the battery rack 1200.

The detection device 210 may include, for example, a heat detector using a resistor such as a thermistor of which a resistance value sensitively changes according to a temperature change, a smoke detector including a photoelectric element that detects smoke generated by a fire, an infrared detector including an infrared sensor that detects infrared rays emitted from a flame, or the like.

The cover member 230 may be arranged to surround the entire detection device 210 fixed to the first bracket 221. In this case, the second bracket 222 located at one side of the first bracket 221 may protrude outward through the opening 250 of the cover member 230.

The cover member 230 may include, for example, the first cover member 231 and the second cover member 232.

The first cover member 231 may include a conductive material, may include a polyhedral shape or a dome shape, and may be arranged to cover an upper portion of the detection device 210 fixed to the first bracket, and the second cover member 232 may include a conductive material, may include a polyhedral shape or a dome shape, and may be arranged to cover a lower portion of the detection device 210.

As an example, one area of the second cover member 232 may include a mesh, and the other area except for one area including the mesh may include a coupling area arranged to overlap the first cover member 231.

For example, when the coupling member 21 is located in the coupling portion 260, the conductor wire 240 to be described below may be located in the coupling portion 260 together with the coupling member 21 so that one side of the conductor wire 240 may be fixed to the coupling portion 260 by the coupling member 21.

The mesh positioned in one area of the second cover member 232 may include, for example, a conductive material, and as a specific example, may include a metal thread.

For example, a plurality of metal threads may be arranged to intersect each other to form a plurality of holes in the mesh, and the mesh may be manufactured in various forms according to a method of intersecting the metal threads.

A mesh may be manufactured in the form of plain weave, twill weave, or crimp weave according to a method of intersecting metal threads. In this case, a plurality of intersecting metal threads may be spaced apart from each other to manufacture a mesh including a plurality of holes.

For example, by arranging the mesh in one area of the second cover member 232 of the cover member 230 that surrounds the detection device 210, the cover member 230 may allow smoke generated together with a fire to easily pass therethrough, thereby allowing smoke to be detected by the detection device 210, and foreign materials such as dust may be blocked to prevent or reduce exposure of the detection device 210 to foreign materials or contaminants, thereby preventing or reducing a deterioration in performance. In addition, the mesh may be made of a conductive metal thread to block radiation noise caused by electromagnetism generated by surrounding electronic devices, thereby preventing or reducing a malfunction of the detection device 210.

For example, a size of a mesh may be in a range of 30 mesh to 60 mesh, and in this case, a unit of the mesh may be defined as the number of holes included in a 1 square inch area (2.54 cm×2.54 cm) of the mesh. Specifically, 30 mesh may mean that the number of holes included in a 1 square inch area (2.54 cm×2.54 cm) of the mesh is 30.

The mesh included in the cover member 230 may have different hole sizes according to mesh sizes. For example, as a mesh size decreases, a hole size may increase, and as a mesh size increases, as an example, a hole size may decrease.

For example, a size of a hole refers to the longest length when the hole is measured. For example, when a hole has a circular shape, a size of the hole may be a diameter of a line passing through the center. When a hole has a quadrangular shape, a size of the hole may be a length of a diagonal.

For example, a size of the hole may be in a range of 0.29 mm to 0.62 mm. When the mesh may have such a size of a hole, the mesh may effectively block the passage of radiation noise and effectively allow the passage of smoke.

As an example, when the size of the mesh is 30 mesh or more, the size of the hole may be 0.62 mm or less, and when the size of the mesh is 60 mesh or less, the size of the hole may be 0.29 mm or more.

For example, a diameter of a metal thread may vary according to a size of a mesh, and a diameter of the metal thread may have different values according to each size of the mesh.

In some embodiments, when the size of the mesh is less than 30 mesh, it may be difficult to block radiation noise, and when the size of the mesh exceeds 60 mesh, there may be a problem in that it takes a long time for the detection device 210 to detect smoke because it is difficult for smoke generated together with a fire to pass through the mesh.

For example, when the size of the hole is less than 0.29 mm, there may be a problem in that it takes a long time for the detection device 210 to detect smoke because it is difficult for smoke generated together with a fire to pass through the hole, and when the size of the hole exceeds 0.62 mm, it may be difficult to block radiation noise.

According to some embodiments, the conductive material may include at least one selected from copper, aluminum, nickel, stainless steel, or silver.

According to some embodiments, a surface of the conductive material may be additionally plated with tin or zinc, and by plating the surface of the conductive material with tin or zinc, corrosion of the conductive member may be prevented or reduced.

The conductor wire 240 may be positioned such that one side thereof is in contact with at least one area of the cover member 230, and the other side thereof may be grounded. As a specific example, the conductor wire 240 may be positioned such that one side thereof is in contact with the coupling portion 260 of the cover member 230, and the other side of the conductor wire 240 may be in contact with the battery rack 1200 and may be grounded.

One side of the conductor wire 240 may be in contact with the cover member 230, and the other side of the conductor wire 240 may be in contact with the battery rack 1200 and grounded so that radiation noise due to electromagnetic waves may flow along the cover member 230 made of a conductive material and then may flow to the battery rack 1200 along the conductor wire 240 in contact with the cover member 230. The battery rack 1200 may be grounded, and thus radiation noise may finally flow to a ground surface. In this way, radiation noise may flow to a ground surface along the cover member 230 and the conductor wire 240 so that the cover member 230 may block radiation noise flowing toward the detection device 210, and the cover member 230 may block radiation noise radiated to the detection device so that a malfunction of the detection device 210 due to radiation noise may be prevented or reduced.

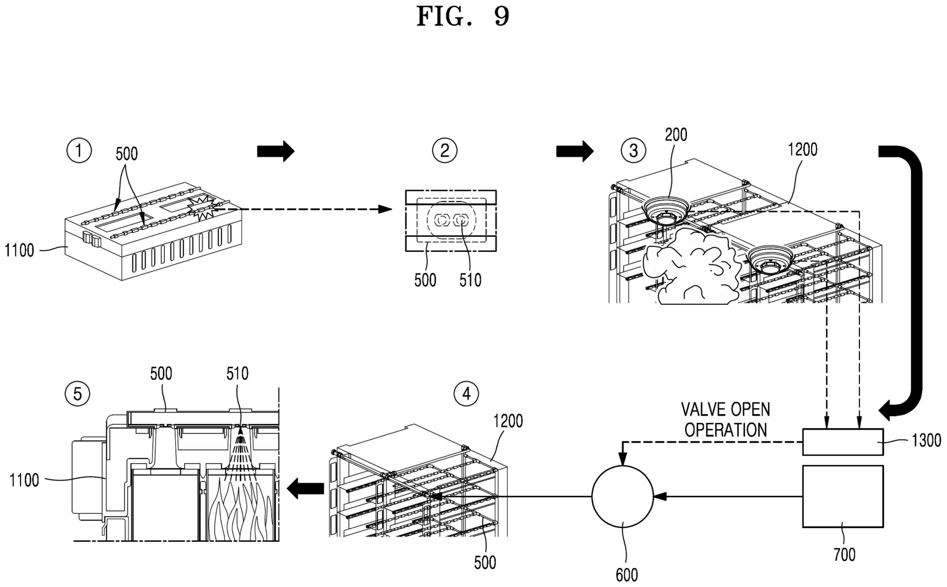

FIG. 9 shows schematic views illustrating an example of the operation of a fire extinguishing system of an energy storage system.

Referring to FIG. 9, the fire extinguishing system of the energy storage system may include, for example, a direct spray system. In the direct spray system, ① when an event occurs in a battery cell accommodated in a battery module 1100, smoke may be generated, ② a spray nozzle 500 may be melted and opened by heat and flames generated in the battery cell to form a spray hole 510, ③ when a concentration of smoke generated in the battery cell increases, a fire detector 200 may detect the smoke to generate an electrical signal, ④ a control device 1300 that receives a signal of the fire detector 200 may operate a solenoid valve 600 to move an extinguishing agent positioned in an extinguishing agent container 700 to the spray nozzle 500, and ⑤ the extinguishing agent may be intensively sprayed onto the battery cell accommodated inside the battery module 1100 through the spray hole 510.

In the case of the direct spray system, a system may be operated by an electrical signal of the fire detector 200, and thus when the fire detector 200 continuously malfunctions to generate an electrical signal, the malfunction may lead to a malfunction of the entire system, which make it difficult to take appropriate measures in the event of an actual fire.

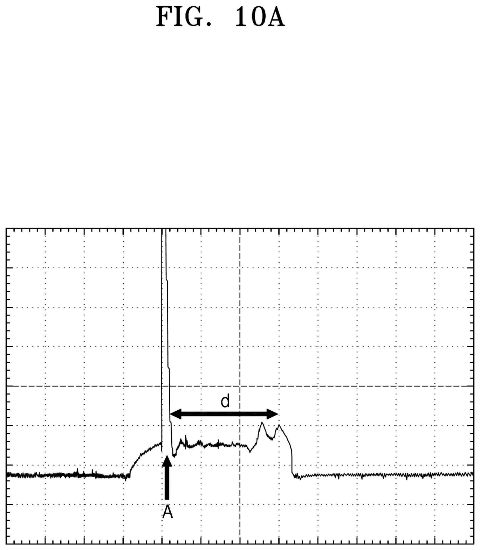

FIGS. 10A to 10C are graphs showing a detection waveform of a fire detector.

Referring to FIG. 10A, the graph shows a normal waveform of the fire detector. It may be confirmed that, after a peak is observed at a detection start point A, a waveform is constantly maintained in a detection section d.

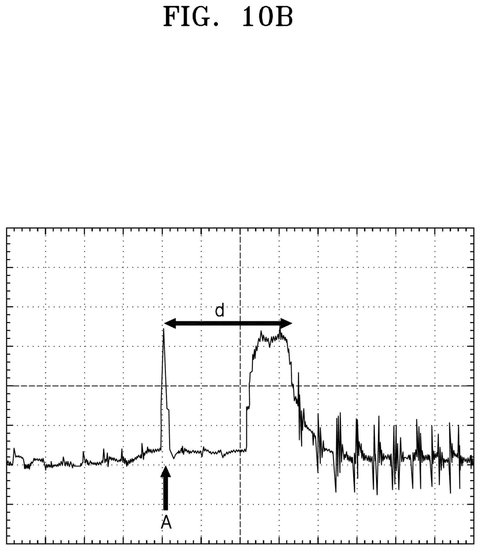

Referring to FIG. 10B, the graph shows a waveform when smoke is detected by the fire detector. It may be confirmed that, after a peak is observed at a detection start point A, another peak is additionally observed in a detection section d.

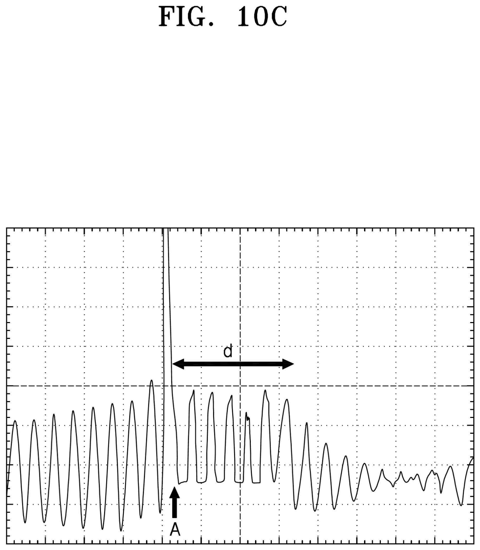

Referring to FIG. 10C, the graph shows a waveform of the fire detector during charging or discharging of a battery. It may be confirmed that, after a peak is observed at a detection start point A, a plurality of peaks are observed in a detection section d, and thus a waveform is distorted.

That is, when a fire detector not including a cover member is located in an energy storage system, radiation noise may be generated due to a charging or discharging operation of a battery, and it may be seen that the radiation noise causes a malfunction of the fire detector.

**[Table 1]**

| Mesh size | Wire diameter (mm) | Hole size (mm) |
|---|---|---|
| 10 mesh | 0.4 | 2.2 |
| 20 mesh | 0.29 | 0.98 |
| 30 mesh | 0.23 | 0.62 |
| 40 mesh | 0.18 | 0.46 |
| 60 mesh | 0.14 | 0.29 |
| 80 mesh | 0.12 | 0.2 |
| 100 mesh | 0.1 | 0.154 |

Table 1 shows a wire diameter and a hole size according to a mesh size.

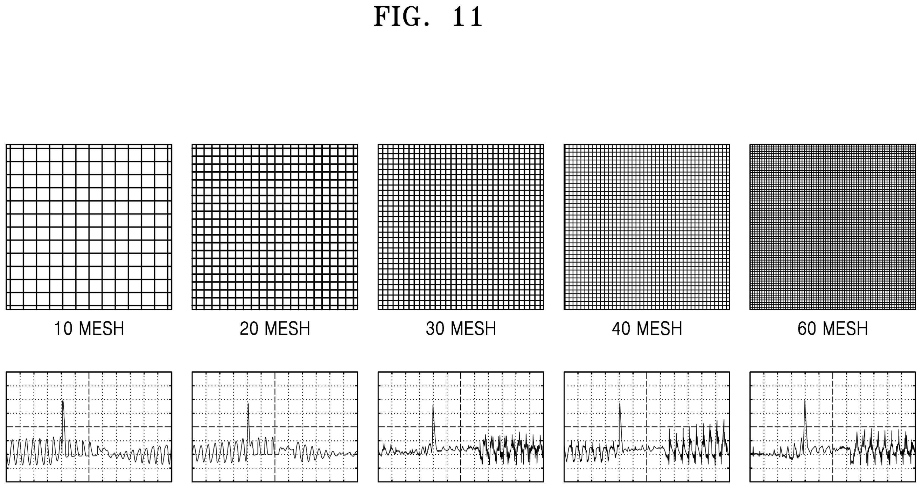

FIG. 11 shows graphs showing a detection waveform of a fire detector according to a mesh size. In this case, a used mesh may be a mesh having the same conditions as those described in Table 1.

Referring to FIG. 11, when a battery is charged or discharged, a detection waveform of the fire detector according to a mesh size of a cover member covering a detection device may be confirmed.

At 10 mesh and 20 mesh, it can be confirmed that the detection waveform of the fire detector is distorted, but at 30 mesh, 40 mesh, and 60 mesh, it can be confirmed that the detection waveform of the fire detector is constantly maintained.

**[Table 2]**

| Nominal concentration (%/m) | No mesh | Mesh (#40) | Mesh (#60) | Mesh (#80) | Mesh (#100) |
|---|---|---|---|---|---|
| 22.5 | 9 | 10 | 31 | 32 | 63 |
| 20 | 5 | 10 | 37 | 35 | 66 |
| 17.5 | 11 | 14 | 41 | 41 | 65 |
| 15 (nominal concentration) | 6 | 10 | 37 | 44 | 79 |
| 12.5 | 12 | 10 | 46 | 44 | 108 |
| 10 | 8 | 10 | 99 | 83 | Nonoperation (for 5 minutes or more) |
| Average detection time | 10.3 | 10.7 | 48.5 | 46.5 | 76.2 |

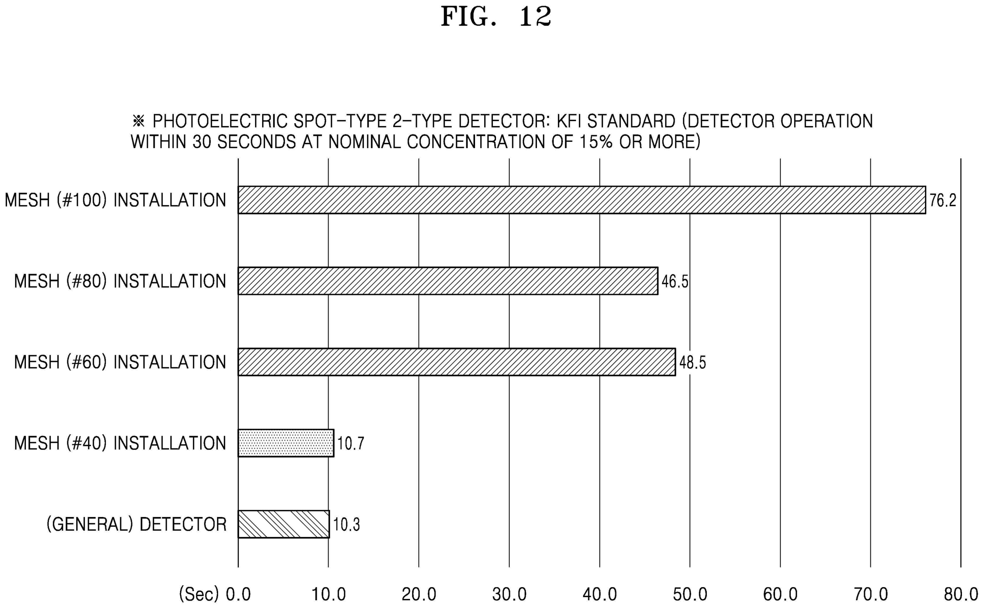

Table 2 is a table showing a detection operation time of a fire detector according to a mesh size and a nominal concentration, and FIG. 12 is a graph showing a response time of a fire detector according to a mesh size. In this case, a used mesh may be a mesh having the same conditions as those described in Table 1.

Referring to Table 2 and FIG. 12, Table 2 shows a detection operation time according to a nominal concentration and a mesh size, and FIG. 12 shows a detection operation time at a nominal concentration of 15% or more which is the Korean Fire and Safety Institute (KFI) standard.

When there is no mesh, that is, in the case of a fire detector not including a cover member, it can be confirmed that the detection operation time is fastest, and in the case of a fire detector including a cover member with a mesh of 40 mesh, it can be confirmed that there is no significant difference in the detection operation time as compared to the fire detector not including the cover member. In other embodiments, in the case of a fire detector including a cover member with a mesh of 60 mesh or more, it can be confirmed that the detection operation time is significantly slow.

For example, a hole size in the case of 30 mesh may be greater than that in the case of 40 mesh, and thus it may be expected that the detection operation time at 30 mesh may be similar to or earlier than that at 40 mesh.

In summary, when a size of a mesh included in a cover member covering a detection device is in a range of 30 mesh to 60 mesh, the performance of blocking radiation noise may be excellent, and a smoke detection operation may be performed quickly.

As a result, in an energy storage system according to embodiments of the present invention, a cover member may be arranged to surround a detector, and a conductor wire in contact with at least one area of the cover member may be included to prevent or reduce a malfunction of a fire detector and a malfunction of a fire extinguishing system, thereby relatively improving stability.

According to embodiments of the present invention, in a fire detector, a cover member may be arranged to surround a detector, thereby relatively reducing a malfunction of the detector and relatively improving stability.

In addition, in an energy storage system according to embodiments of the present invention, by arranging a cover member to surround a detector, a fire detector may be arranged to relatively reduce a malfunction of the detector, thereby relatively improving stability.

Although aspects of some embodiments of the present invention have been described with reference to aspects of some embodiments as shown and described with respect to the drawings, embodiments according to the present invention are not limited to thereto, and instead, it would be appreciated by those skilled in the art that various modifications and changes may be made to these embodiments without departing from the principles and spirit of the present invention, the scope of which is defined by the claims and their equivalents.

## Claims

1. A fire detector (100, 200) comprising:
a detection device (110, 210);
a cover member (120, 230) surrounding the detection device (110, 210); and
a conductor wire (240) positioned such that one side thereof contacts at least one area of the cover member (120, 230),
wherein the cover member (120, 230) comprises a mesh, and another side of the conductor wire (240) is grounded.

2. The fire detector (100, 200) according to claim 1, wherein the mesh has a size of 30 mesh to 60 mesh.

3. The fire detector (100, 200) according to claim 1 or 2, wherein
the mesh comprises a plurality of holes, and
the plurality of holes have a size in a range of 0.29 millimeters (mm) to 0.62 mm.

4. The fire detector (100, 200) according to any one of the preceding claims, wherein the mesh comprises a conductive material,
wherein the conductive material is at least one selected from copper, aluminum, nickel, stainless steel, or silver.

5. The fire detector (100, 200) according to any one of the preceding claims, wherein
the cover member (230) comprises a first cover member (231) and a second cover member (232) which are coupled to each other,
the first cover member (231) has a first concave portion (251) formed in one surface of the first cover member (231),
the second cover member (232) has a second concave portion (252) formed in one surface of the second cover member (232), and
the first concave portion (251) and the second concave portion (252) are positioned to overlap each other when the first cover member (231) and the second cover member (232) are coupled to each other.

6. An energy storage system (1000) comprising:
a plurality of battery modules (1100);
a battery rack (1200) on which the plurality of battery modules (1100) are mounted;
at least one fire detector (200) on an upper end of the battery rack (1200); and
a control device (1300) electrically connected to the plurality of battery modules (1100) and the at least one fire detector (200),
wherein the at least one fire detector (200) comprises a conductor wire (240), and
the conductor wire (240) has one side contacting at least one area of the at least one fire detector (200) and another side contacting the battery rack (1200).

7. The energy storage system (1000) according to claim 6, wherein
the at least one fire detector (200) further comprises a detection device (210), and a cover member (230) surrounding the detection device (210),
the one side of the conductor wire (240) contacts at least one area of the cover member (230), and
the cover member (230) comprises a mesh.

8. The energy storage system (1000) according to claim 7, wherein the mesh has a size of 30 mesh to 60 mesh.

9. The energy storage system (1000) according to claim 7 or 8, wherein
the mesh comprises a plurality of holes, and
the plurality of holes each have a size of 0.29 mm to 0.62 mm.

10. The energy storage system (1000) according to any of claims 7 to 9, wherein the mesh comprises a conductive material,
wherein the conductive material is at least one selected from copper, aluminum, nickel, stainless steel, or silver.

11. The energy storage system (1000) according to any of claims 7 to 10, wherein
the cover member (230) comprises a first cover member (231) and a second cover member (232) which are coupled to each other,
the first cover member (231) has a first concave portion (251) formed in one surface of the first cover member (231),
the second cover member (232) has a second concave portion (252) formed in one surface of the second cover member (232), and
the first concave portion (251) and the second concave portion (251) overlap each other when the first cover member (231) and the second cover member (232) are coupled to each other.

12. The energy storage system (1000) according to claim 11, wherein
a first opening (261) is positioned in another surface of the first cover member (231) which intersects the one surface in which the first concave portion (251) of the first cover member (231) is formed,
a second opening ( 262) is positioned in another surface of the second cover member (232) which intersect with the one surface in which the second concave portion (252) of the second cover member (232) is formed, and
the first opening (261) and the second opening (262) overlap each other when the first cover member (231) and the second cover member (232) are coupled to each other.

13. The energy storage system (1000) according to claim 12, wherein the one side of the conductor wire (240) contacts an area in which the first opening (261) and the second opening (262) overlap each other when the first cover member (231) and the second cover member (232) are coupled to each other.

14. The energy storage system (1000) according to any of claims 7 to 13, further comprising:
a first bracket (221) to which the detection device (210) is fixed; and
a second bracket (222) at one side of the first bracket (221),
wherein the second bracket (222) is fixed to the battery rack (1200).

15. The energy storage system (1000) according to any of claims 6 to 14, wherein the other side of the conductor wire (240) is grounded.
